# EUROPEAN PATENT APPLICATION

(11) **EP 4 819 198 A1**
(43) Date of publication of application: **07.10.2026**
(21) Application number: 24897415.6
(22) Date of filing: 20.11.2024
(51) Int. Cl.: H01L 21/304, C11D 7/08, C11D 7/22, C11D 7/26, C11D 7/34

(54) **CLEANING LIQUID, CLEANING METHOD, AND METHOD FOR MANUFACTURING SEMICONDUCTOR ELEMENT**

(30) Priority: 27.11.2023 JP 2023199775
(71) Applicant: AGC Inc., Chiyoda-ku Tokyo 100-8405 (JP)
(72) Inventor: IWAMOTO Hiroaki, Tokyo 100-8405 (JP)
(74) Representative: Müller-Boré & Partner Patentanwälte PartG mbB
(86) International application number: PCT/JP2024/041161
(87) International publication number: WO 2025/115729

(57) **Abstract**

A cleaning liquid with an excellent removing ability for abrasive grains, capable of suppressing foaming of the cleaning liquid and effectively removing abrasive grains and organic components which have adhered to an object to be cleaned, a cleaning method using such a cleaning liquid, and a method for manufacturing a semiconductor device are provided. A cleaning liquid for removing a cerium compound, comprises a water-soluble polymer (A) comprising a sulfonic acid group-containing water-soluble polymer (a1), wherein pH is 7 or lower, and a surface tension of an aqueous solution comprising the water-soluble polymer (A) at a concentration of 0.1 mass%, measured by a pendant drop method at 22°C is 68 mN/m or higher.

## Description

### Technical Field

The present invention relates to a cleaning liquid, a cleaning method, and a method for manufacturing a semiconductor device.

### Background Art

In semiconductor apparatus such as semiconductor devices, packing densities are increasing in order to enhance the performance, and semiconductor elements such as transistors becoming finer and the numbers of layers for their wiring lines are increasing.

Examples of a method for manufacturing a semiconductor device include a method for successively forming a conductive film, an insulating film, a resist film, and the like on a semiconductor substrate such as a silicon wafer, forming a circuit pattern through processes such as lithography and etching, further forming an oxide film, and then flattening the formed laminate by performing a chemical mechanical polishing (CMP: Chemical Mechanical Polishing) process. Further, a multilayer semiconductor device may be formed by laminating (e.g., forming) a new layer(s) on the flattened surface.

In CMP, the polishing is performed by using an abrasive slurry comprising abrasive particles (also called abrasive grains). In CMP for a silicon compound film such as a silicon dioxide film and a silicon nitride film, particles comprising a cerium compound are preferably used as abrasive grains in order to improve the polishing rate.

Unnecessary components such as abrasive components (e.g., abrasive grains and organic components such as polymers) and abrasive debris may exist (i.e., remain) on the surface of the semiconductor device after the CMP process. Therefore, it is common to clean a semiconductor device with a cleaning liquid after a CMP process.

In general, particles comprising a cerium compound may bond with the surface of a silicon compound film such as a silicon dioxide film and a silicon nitride film during the CMP process, or may strongly adhere to the surface due to an attractive force caused by a zeta potential under an acidic condition, so that it may be difficult to remove the particles. Therefore, semiconductor devices have been cleaned by using a strong chemical agent such as diluted hydrofluoric acid and a sulfuric acid/hydrogen peroxide mixture in the past, but the development of a cleaning liquid with a better handling property has been in progress.

For example, Patent Literature 1 discloses a specific cleaning agent composition comprising a specific polymer having a carboxylic acid group and a sulfonic acid group, a specific polymer comprising a structural unit derived from an aromatic monomer having a sulfonic acid group, sulfuric acid, a reducing agent, and water.

### Citation List

### Patent Literature

[Patent Literature 1] Japanese Unexamined Patent Application Publication No. 2018-046153

### Summary of Invention

### Technical Problem

According to Patent Literature 1, the cleaning liquid disclosed therein improves the cleaning ability for ceria by a combination of two types of polymers. However, this cleaning liquid has a problem in terms of the handling property, such as a low surface tension and poor foam breakage, especially under an acidic condition.

An object of the present disclosure is to provide a cleaning liquid with an excellent removing ability for abrasive grains, capable of effectively removing abrasive grains and organic components which have adhered to an object to be cleaned while suppressing foaming of the cleaning liquid, and also provide a cleaning method using such a cleaning liquid and a method for manufacturing a semiconductor device.

### Solution to Problem

The present disclosure provides a cleaning liquid for removing abrasive grains, a cleaning method, and a method for manufacturing a semiconductor device described below.
[1] A cleaning liquid for removing a cerium compound, comprising a water-soluble polymer (A) comprising a sulfonic acid group-containing water-soluble polymer (a1), wherein
   pH is 7 or lower, and
   a surface tension of an aqueous solution comprising the water-soluble polymer (A) at a concentration of 0.1 mass%, measured by a pendant drop method at 22°C is 68 mN/m or higher.
[2] The cleaning liquid according to Item [1], wherein the sulfonic acid group-containing water-soluble polymer (a1) has one or more types of repeating units selected from an aromatic sulfonic acid, a perfluoroalkyl sulfonic acid, and salts thereof.
[3] The cleaning liquid according to Item [1] or [2], wherein a ratio (Nc/Ns) of the number of carbons (Nc) excluding counter-cations of a sulfonic acid group contained in the repeating unit having at least one sulfonic acid group, contained in the sulfonic acid group-containing water-soluble polymer (a1) to a total number (Ns) of sulfonic acid groups and salts thereof is 7 to 15.
[4] The cleaning liquid according to any one of Items [1] to [3], further comprising a reducing compound (B).
[5] The cleaning liquid according to Item [4], wherein the reducing compound (B) comprises one or more types of compounds selected from the group consisting of gallic acid, gallic acid esters, pyrogallol, ascorbic acid, uric acid, pyrophosphoric acid, and oxalic acid.
[6] The cleaning liquid according to any one of Items [1] to [5], further comprising an acidic compound (C) other than the water-soluble polymer (A) and the reducing compound (B).
[7] The cleaning liquid according to Item [6], wherein the acidic compound (C) comprises an organic compound having at least one substituent selected from a carboxyl group, a phosphoryl group, a sulfonic acid group, and a hydroxyl group in a molecule and having a molecular weight of 1,000 g/mol or lower, and one or more types of acids selected from sulfuric acid, nitric acid, and phosphoric acid.
[8] The cleaning liquid according to Item [6], wherein the acidic compound (C) comprises an organic compound having at least two substituents selected from a carboxyl group, a phosphoryl group, a sulfonic acid group, and a hydroxyl group in a molecule and having a molecular weight of 1,000 g/mol or lower.
[9] The cleaning liquid according to any one of Items [1] to [8], wherein pH is 1 to 5.
[10] The cleaning liquid according to any one of Items [1] to [9], further comprising a preservative.
[11] The cleaning liquid according to any one of Items [1] to [10], wherein the sulfonic acid group-containing water-soluble polymer (A) having the sulfonic acid is contained in 0.001 to 10 mass%.
[12] The cleaning liquid according to any one of Items [1] to [11], wherein the reducing compound (B) is contained in 0.001 to 10 mass%.
[13] The cleaning liquid according to any one of Items [1] to [12], wherein the acidic compound (C) is contained in 0.001 to 10 mass%.
[14] The cleaning liquid according to any one of Items [1] to [13], wherein a Ross-Miles foam height at 25°C is 30 mm or lower.
[15] The cleaning liquid according to any one of Items [1] to [14], wherein an amount of elution of Cu when a silicon substrate on which a Cu film is formed is submerged in 12 mL of an aqueous solution comprising the water-soluble polymer (A) at 25°C for 10 minutes is 3.0 ppm or less.
[16] The cleaning liquid according to any one of Items [1] to [15], wherein the cleaning liquid is for cleaning a semiconductor substrate to which a cerium compound has adhered.
[17] The cleaning liquid according to Item [16], wherein the semiconductor substrate has an exposed surface comprising a metal wiring line on at least a part thereof.
[18] The cleaning liquid according to any one of Items [1] to [15], wherein the cleaning liquid is for cleaning a brush to which a cerium compound has adhered, used for cleaning a semiconductor substrate.
[19] The cleaning liquid according to any one of Items [1] to [15], wherein the cleaning liquid is for cleaning an object to be cleaned of which a surface has been polished by using an abrasive comprising cerium compound-containing particles.
[20] The cleaning liquid according to Item [19], wherein an average particle diameter of the cerium compound-containing particles is 300 nm or smaller.
[21] A cleaning method comprising cleaning a surface to be cleaned to which a cerium compound has adhered by using a cleaning liquid according to any one of Items [1] to [15].
[22] A method for manufacturing a semiconductor device comprising preparing a semiconductor substrate polished with an abrasive comprising cerium compound-containing particles, and cleaning a polished surface of the semiconductor substrate by using a cleaning liquid according to any one of Items [1] to [15].

### Advantageous Effects of Invention

According to the present disclosure, it is possible to provide a cleaning liquid with an excellent removing ability for abrasive grains, capable of effectively removing abrasive grains and organic components which have adhered to an object to be cleaned while suppressing foaming of the cleaning liquid, and also provide a cleaning method using such a cleaning liquid and a method for manufacturing a semiconductor device. Further, it is possible to provide a cleaning liquid capable of, when used on a substrate including metal wiring lines, suppressing corrosion of the metal wiring lines by adding an appropriate additive therein, and also provide a cleaning method using such a cleaning liquid and a method for manufacturing a semiconductor device.

### Description of Embodiments

Embodiments according to the present invention will be described hereinafter. The present invention is not limited to the below-shown embodiments, and other embodiments may also fall within the scope of the present invention as long as they are consistent with the purport of the present invention.

Note that in the present disclosure, unless otherwise specified, when a symbol "-" (or "to"), which indicates a numerical range, is used, it means that a numerical value in front of the symbol and that behind the symbol are included as a lower limit value and an upper limit value, respectively, in the range.

"Water-soluble" means that 100 mg or more of the substance of interest is dissolved in 100 g of water at 25°C.

"(Meth) acryl" is a generic term for "methacryl" and "acryl", it also applies to (meth)acryloyl, (meth)acrylate and the like.

Further, "sulfonic acid group-containing water-soluble polymer (a1)" may be referred to as "water-soluble polymer (a1)", and "water-soluble polymer (A) comprising a sulfonic acid group-containing water-soluble polymer (a1)" may be referred to as "water-soluble polymer (A)".

### [Cleaning Liquid]

A cleaning liquid for removing a cerium compound according to the present disclosure comprises a water-soluble polymer (A) comprising a sulfonic acid group-containing water-soluble polymer (a1), wherein pH is 7 or lower, and a surface tension of an aqueous solution comprising the water-soluble polymer (A) at a concentration of 0.1 mass%, measured by a pendant drop method at 22°C is 68 mN/m or higher.

In the cleaning liquid disclosed herein, the water-soluble polymer (a1) appropriately controls a zeta potential and hinders the adsorption or bonding between the object to be cleaned and the cerium compound, so that the cerium compound and organic components which have adhered to the object to be cleaned are easily removed. Further, the sulfonic acid group contained in the water-soluble polymer (a1) is less likely to be protonated compared with a carboxylic acid group or the like even under an acidic condition, and its ionicity is hence maintained, so that the aggregation of sulfonic acids is suppressed and the surface tension is maintained. Further, since the ionicity of the sulfonic acid group is maintained, the cleaning liquid disclosed herein exhibits excellent cleaning performance under the acidic condition. Further, the cleaning liquid disclosed herein comprises the water-soluble polymer (A) of which the surface tension of an aqueous solution at a concentration of 0.1 mass%, measured at 22°C by a pendant drop method is 68 mN/m or higher, and preferably 70 mN/m or higher, so that foaming is suppressed and the cleaning liquid component can be easily removed from the surface of the object to be cleaned. As a result of these features, the abrasive component can be effectively removed from the surface of the object to be cleaned. The cleaning liquid disclosed herein can be suitably used for removing a cerium compound. In particular, cerium compound-containing particles bonded or adhered to the surface of the substrate after the CMP process can be effectively removed. Further, since the foam breakage of the cleaning liquid disclosed herein is excellent, it is suitable for cleaning a brush for cleaning a semiconductor substrate used in a CMP process, and the brush can be cleaned in a short time.

Note that the cerium compound includes cerium compound-containing particles and the like, and includes abrasive grains comprising a cerium compound. Examples of cerium compounds include ceria and cerium hydroxide.

### <pH>

pH of the cleaning liquid disclosed herein is 7 or lower in order to improve the cleaning ability, and is preferably 1 to 6 and more preferably 1 to 5 in order to further improve the cleaning ability. pH of the cleaning liquid disclosed herein may be adjusted by adjusting the type and/or the content ratio of the water-soluble polymer (A), or by using an acidic compound described later. In the present disclosure, pH is a value at 25°C and can be measured by using a pH meter.

### <Surface Tension>

The surface tension of the water-soluble polymer (A) contained in the cleaning liquid disclosed herein is characterized in that the surface tension of an aqueous solution comprising the water-soluble polymer (A) at a concentration of 0.1 mass% at 22°C is 68 mN/m or higher. The surface tension of the cleaning liquid disclosed herein can be adjusted by the structure of the water-soluble polymer (A) and/or the mass-average molecular weight thereof. Note that the upper limit value of the surface tension is not limited to any particular values, but is typically 72.4 mN/m equivalent to the surface tension of water at 22°C.

In the present disclosure, a value measured by a pendant drop method at 22°C is used for the surface tension. Specifically, a liquid (cleaning liquid) is dropped from the tip of a vertically-disposed narrow tube (injection needle); the shape of the largest hanging drop (drop) that is not dropped is photographed; and then, the surface tension is calculated by analyzing the obtained image by a ds/de method.

The aqueous solution for measuring the surface tension is prepared by dissolving the water-soluble polymer (A) used for the cleaning liquid in water and adjusting its concentration to 0.1 mass%. When the water-soluble polymer (A) comprises two or more types of polymers, the ratio of each of the polymers is adjusted to a ratio equivalent to that of the cleaning liquid. Further, it is sufficient if the aqueous solution is acidic, and pH may be adjusted to 7 or lower.

The Ross-Miles foam height of the cleaning liquid disclosed herein is preferably 30 mm or lower. The Ross-Miles foam height is more preferably 20 mm or lower and particularly preferably 5 mm or lower. When the Ross-Miles foam height is within the above-described range, foam is unlikely to form in pipes and in the apparatus when the cleaning liquid is diluted and supplied.

The Ross-Miles foam height is measured by a method described in JIS K 3362 which is also described below.

50 mL of a cleaning liquid was put in the lower part of a glass tube having a diameter of 50 mm in advance; a certain amount (200 mL) of the cleaning liquid was dropped from the upper part of the glass tube over 30 seconds; and a foaming ability was measured by reading (i.e., measuring) the height (mm) of the formed foam 30 seconds after the dropping. It is indicated that the higher the height of the foam is, the more the foam is likely to form.

Regarding the cleaning agent disclosed herein, an amount of elution of Cu when a silicon substrate on which a Cu film is formed is submerged in 12 mL of an aqueous solution comprising the water-soluble polymer (A) at 25°C for 10 minutes is preferably 3.0 ppm or less. The amount of elution of Cu is more preferably 2.5 ppm or less and particularly preferably 2.0 ppm or less. When the amount of elution of Cu is in the above-described range, the etching rate of the Cu film is 0.5 nm/min or lower, and it is a range in which the film thickness of the Cu film is not significantly affected by the cleaning liquid.

The cleaning liquid disclosed herein comprises at least the water-soluble polymer (A) and water, and may contain other components in a range in which the present invention is effective. Each of the components that may be contained in the cleaning liquid disclosed herein will be described hereinafter.

### <Water-Soluble Polymer (A)>

The water-soluble polymer (A) comprises at least a sulfonic acid group-containing water-soluble polymer (a1), and may contain another water-soluble polymer(s) (a2). Each of the water-soluble polymers will be described hereinafter.

### (Sulfonic Acid Group-containing Water-Soluble Polymer (a1))

The water-soluble polymer (a1) is a water-soluble polymer having at least one sulfonic acid group in the molecule. Note that the sulfonic acid group contained in the water-soluble polymer (a1) may be in the form of an ion or a salt.

In the case where the sulfonic acid group forms a salt, specific examples of counter-cations include alkali metal ions such as a sodium ion and a potassium ion; an ammonium ion; a phosphonium ion; and a sulfonium ion. Further, the counter-cation is preferably an ammonium ion in order to further improve the cleaning ability.

Specific examples of ammonium ions include a methylammonium ion, a dimethylammonium ion, a trimethylammonium ion, an ethylammonium ion, a triethylammonium ion, an n-propylammonium ion, an isopropylammonium ion, an n-butylammonium ion, a tert-butylammonium ion, a hexylammonium ion, a 2-hydroxyethylammonium ion, an N,N-dimethyl-N-(2-hydroxyethyl) ammonium ion, an N-methyl-N-(2-hydroxyethyl) ammonium ion, a di(2-hydroxyethyl) ammonium ion, an N-methyl-N,N-di(2-hydroxyethyl) ammonium ion, a N,N,N-tri(2-hydroxyethyl) ammonium ion, a 2,3-dihydroxypropylammonium ion, an N-methyl-N-(2,3-dihydroxypropyl) ammonium ion, an N,N-dimethyl-N-(2,3-dihydroxypropyl) ammonium ion, a triisobutylammonium ion, a triisopentylammonium ion, a triisooctylammonium ion, an imidazolium ion, an N-methylimidazolium ion, a tetramethylammonium ion, a tetraethylammonium ion, a tetrapropylammonium ion, a tetrabutylammonium ion, an ethyltrimethylammonium ion, a diethyldimethylammonium ion, a methyltriethylammonium ion, and an ammonium ion (NH₄⁺).

The water-soluble polymer (a1) preferably has one or more types of repeating units selected from an aromatic sulfonic acid, a perfluoroalkyl sulfonic acid, and salts thereof in order to further improve the cleaning ability.

Examples of the repeating unit of the aromatic sulfonic acid include structures represented by Formulas (1) and (2) shown below.

-CH₂₋CH(-Ar¹SO₃Z¹)- (1)

-CH₂(-Ar²SO₃Z¹)- (2)

where Ar¹ and Ar² are divalent aromatic groups which may have a substituent, and
Z¹ is a hydrogen atom or a cation.

Further, examples of the repeating unit of the perfluoroalkyl sulfonic acid include a structure represented by Formula (3) shown below.

-CF₂₋CF[-O-(R¹O)ₙ-R²⁻SO₃Z¹]- (3)

where,
R¹ is a fluoroalkylene group which contains 1 to 6 carbon atoms and may have a branch,
R² is a fluoroalkylene group containing 1 to 6 carbon atoms,
Z¹ is a hydrogen atom or a cation, and
n is an integer of 0 to 6.

Examples of the aromatic rings in Ar¹ and Ar² include benzene, naphthalene, and anthracene. Further, the aromatic ring is preferably benzene or naphthalene, and more preferably naphthalene in order to further improve the cleaning ability. Examples of substituents that Ar¹ and Ar² may have an alkyl group containing 1 to 6 carbon atoms, and a halogen atom.

The cation in Z¹ is similar to the counter-cation described above.

Specific examples of R¹ include CF₂, CF₂CF₂, CF₂CF₂CF₂, CF₂CF(CF₃), and CF₂CF₂CF₂CF₂.

Specific examples of R² include CF₂, CF₂CF₂, CF₂CF₂CF₂, and CF₂CF₂CF₂CF₂.

The repeating units represented by Formulas (1) and (3) can be suitably obtained by Manufacturing Method (I) described later. Further, the repeating unit represented by Formula (2) can be suitably obtained by Manufacturing Method (II) described later.

A ratio (Nc/Ns) of the number of carbons (Nc) contained in the repeating unit having the sulfonic acid group of the water-soluble polymer (a1) to the total number (Ns) of sulfonic acids and salts thereof is preferably 7 to 15 and more preferably 8 to 12 in order to further improve the cleaning ability and easily control the surface tension of the aqueous solution comprising the water-soluble polymer (A) at a concentration of 0.1 mass% to 68 mN/m or higher. Note that carbons contained in the counter-cation of the sulfonic acid group are not included in the number of carbons contained in the repeating unit having the sulfonic acid group contained in the water-soluble polymer (a1).

Further, in the case of the fluoropolymer comprising the repeating unit of the perfluoroalkyl sulfonic acid, a TQ value (volumetric flow rate value) is preferably 200 to 300°C, more preferably 220 to 300°C, and particularly preferably 240 to 290°C in view of the cleaning ability and the re-adhesion prevention property of the abrasive grains. Note that the TQ value is an index indicating the molecular weight of the fluoropolymer having the sulfonic acid group, and is a temperature at which the amount of extrusion when the aforementioned fluoropolymer is melted and extruded under a condition of an extrusion pressure of 2.94 MPa by using a nozzle having a length of 1 mm and an inner diameter of 1 mm is 100 mm³/sec.

When the TQ value is equal to or higher than the lower limit value of the above-described range, the fluoropolymer has a sufficient molecular weight, so that particles can be effectively dispersed. When the TQ value is equal to or lower than the upper limit value of the above-described range, the solubility of the fluoropolymer is improved, so that a homogeneous solution can be prepared as the cleaning liquid.

Further, in the aforementioned fluoropolymer, the mass-average molecular weight (Mw) of the water-soluble polymer (a1) is preferably 5,000 to 800,000, more preferably 10,000 to 500,000, and particularly preferably 50,000 to 300,000 in order to further improve the cleaning ability and easily control the surface tension of the aqueous solution comprising the water-soluble polymer (A) at a concentration of 0.1 mass% to 68 mN/m or higher. For the other sulfonic acid polymers, the mass-average molecular weight (Mw) is preferably 1,000 to 500,000, more preferably 1,500 to 300,000, and particularly preferably 2,000 to 50,000.

Note that Mw is a value that is obtained as a standard polystyrene equivalent value by gel permeation chromatography (GPC).

The water-soluble polymer (a1) is preferably a polymer obtained by a manufacturing method for a polymer (I) or (II) described below in order to improve the cleaning ability and easily adjust the above-described Nc/Ns and Mw.
(I) A polymer obtained by (co)polymerizing a monomer having a sulfonic acid group and another monomer(s) to be used as required.
(II) A polymer obtained by condensing an aromatic sulfonic acid, another aromatic compound(s) to be used as required, and formaldehyde.

### (Manufacturing Method (I))

Manufacturing Method (I) comprises mixing, as a monomer(s), a monomer having an ethylenic unsaturated bond and a sulfonic acid group, and another monomer(s) as required, adding an initiator, and polymerizing the monomer(s) by a known polymerization method such as solution polymerization, bulk polymerization, or any of various types of radical polymerization. The solution polymerization is preferred because Mw of the water-soluble polymer (a1) can be easily adjusted. Further, in the case of a block polymer, for example, a block of a monomer having a sulfonic acid may be synthesized in advance, and then another monomer(s) may be mixed with the block and they may be polymerized. Alternatively, the order of syntheses may be reversed in this manufacturing method.

Examples of monomers having a sulfonic acid group include a monomer having an aromatic sulfonic acid such as styrenesulfonic acid and vinylnaphthalenesulfonic acid; vinylsulfonic acid, allylsulfonic acid, 2-(meth)acrylamido-2-methyl-1-propanesulfonic acid, 2-sulfoethyl (meth)acrylate, sulfopropyl (meth)acrylate, 3-allyloxy-2-hydroxy-1-propanesulfonic acid, 2-propene-1-sulfonic acid, a perfluorosulfonic acid monomer, and salts thereof. Further, it is possible to use one of them alone or a combination of two or more of them.

The repeating unit of the aromatic sulfonic acid represented by the above-shown Formula (1) is obtained by using the above-described monomer having an aromatic sulfonic acid group.

Further, examples of the aforementioned perfluorosulfonic acid monomer include a monomer represented by Formula (4) shown below.

CF₂=CF-O-(R¹O)ₙ-R²⁻SO₃Z¹ (4)

where R¹, R², Z¹, and n are similar to those in the above-shown Formula (3).

The repeating unit of the perfluoroalkyl sulfonic acid represented by the above-shown Formula (3) is obtained by using the above-described monomer having an aromatic sulfonic acid group.

Specific examples of the perfluorosulfonic acid monomer represented by Formula (4) include those shown below.

CF₂=CFOCF₂CF(CF₃)OCF₂CF₂SO₃H

CF₂=CFOCF₂CF₂CF₂OCF₂CF₂SO₃H

CF₂=CFOCF₂CF₂OCF₂CF₂SO₃H

CF₂=CFOCF₂CF₂SO₃H

CF₂=CFOCF₂CF₂CF₂SO₃H

CF₂=CFOCF₂CF₂CF₂CF₂CF₂SO₃H

In order to adjust the ratio of the sulfonic acid group contained in the water-soluble polymer (a1), a monomer having no sulfonic acid group, preferably a monomer having no acidic group, may be combined as required.

Specific examples of monomers having no sulfonic acid group include vinyl-based monomers such as ethylene, vinyl chloride, vinylidene chloride, styrene, methyl styrene, vinyl toluene, and p-t-butyl styrene; (meth)acrylate-based monomers such as methyl (meth)acrylate, ethyl (meth)acrylate, and n-propyl (meth)acrylate; acrylamide-based monomers such as (meth)acrylamide, N,N-dimethyl (meth)acrylamide, and N,N-diethyl (meth)acrylamide; and bifunctional vinyl monomers such as maleic anhydride, monoethyl maleic acid, monoethyl fumaric acid, diethyl maleic acid, and diethyl fumaric acid. These monomers are preferably used in combination with the monomer having an aromatic sulfonic acid group.

Further, monomers having no sulfonic acid group used in combination with the perfluorosulfonic acid monomer include a monomer represented by Formula (5) shown below.

CF₂=CFL¹ (5)

where L¹ is a fluorine atom, a chlorine atom, or O-(R¹¹O)ₙ₁-R¹²,
R¹¹ is a fluoroalkylene group which contains 1 to 6 carbon atoms and may have a branch,
R¹² is a fluoroalkyl group containing 1 to 6 carbon atoms, and
n1 is an integer of 0 to 6.

The fluoroalkylene group of R¹¹ is preferably a perfluoroalkylene group.

The fluoroalkylene group of R¹² is preferably a perfluoroalkylene group.

Specific examples of R¹¹ are similar to those of R¹.

Specific examples of R¹² include CF₃, CF₂CF₃, CF₂CF₂CF₃, and CF₂CF₂CF₂CF₃.

Specific examples of the monomer represented by Formula (5) include those shown below.

CF₂=CF₂

CF₂=CFOCF₃

CF₂=CFOCF₂CF₃

CF₂=CFOCF₂CF₂CF₂OCF₂CF₃

### (Manufacturing Method (II))

Manufacturing Method (II) comprises mixing an aromatic sulfonic acid, another aromatic compound(s) to be used as required, and formaldehyde, and performing addition condensation by heating the mixture in the presence of a catalyst.

Examples of aromatic sulfonic acids include a compound represented by Formula (6) shown below.

Ar³SO₃Z¹ (6)

where Ar³ is a monovalent aromatic group which may have a substituent, and
Z¹ is a hydrogen atom or a cation.

The repeating unit of the aromatic sulfonic acid represented by the above-shown Formula (2) is obtained by using the above-described aromatic sulfonic acid.

Examples of the aromatic ring in Ar³ include benzene, naphthalene, and anthracene. Further, the aromatic ring is preferably benzene or naphthalene, and more preferably naphthalene in order to further improve the cleaning ability. Examples of substituents which may have Ar³ include an alkyl group containing 1 to 6 carbon atoms, and a halogen atom. The cation in Z¹ is similar to the counter-cation described above.

In order to adjust the ratio of the sulfonic acid contained in the water-soluble polymer (a1), an aromatic compound having no sulfonic acid group, preferably an aromatic compound having no acidic group, may be combined as required. Examples of the aromatic compound include benzene which may have a substituent, naphthalene, and anthracene, and examples of the substituent include an alkyl group containing 1 to 6 carbon atoms and a halogen atom.

The content of the water-soluble polymer (a1) is preferably 90 mass% or more, more preferably 95 mass% or more, still more preferably 99 mass%, and particularly preferably 99.9 mass% or more based on the total amount (100 mass%) of the water-soluble polymer (A). The content may be 100 mass%.

### (Other Water-soluble Polymer (a2))

The water-soluble polymer (A) may comprise a sulfonic acid group-containing water-soluble polymer (a1), and may comprise another water-soluble polymer(s) (a2) in a range in which the present invention is effective. Examples of other water-soluble polymers (a2) include polymers having one or more types of polar groups selected from a hydroxyl group, a carboxylic acid group, and an amino group.

The content of the other water-soluble polymer (a2) can be adjusted as appropriate within a range of 0.01 to 10 mass% based on the total amount (100 mass%) of the water-soluble polymer (A). However, for example, a polymer having a carboxylic acid group is likely to be protonated under the acidic condition, and as a result, the surface tension and the cleaning performance tend to be lowered. In view of the above-described features, the content of the other water-soluble polymer (a2) based on the total amount of the water-soluble polymer (A) is preferably 5 mass% or less, more preferably 1 mass% or less, and particularly preferably 0.1 mass% or less.

The content of the water-soluble polymer (A) in the cleaning liquid is preferably 0.001 to 10 mass%, more preferably 0.005 to 8 mass%, and particularly preferably 0.01 to 5 mass% based on the total amount (100 mass%) of the cleaning liquid in order to achieve both the cleaning ability and the surface tension. Note that a cleaning liquid comprising the water-soluble polymer (A) at a high concentration may be prepared in advance and then diluted as appropriate when it is used.

### <Water>

The cleaning liquid disclosed herein comprises water as a medium for dissolving the water-soluble polymer (A). The type of water is not limited to any particular types, but it is preferred to use pure water, ultrapure water, ion-exchanged water, or the like in consideration of effects on the other components, the prevention of contamination of impurities, effects on pH, and the like.

### <Reducing Compound (B)>

The cleaning liquid disclosed herein may further comprise a reducing compound (B). By using the cleaning liquid disclosed herein in combination with the water-soluble polymer (A) and the reducing compound (B), the corrosion of the substrate and metal wiring lines is remarkably suppressed. Since the reducing compound (B) reduces, for example, cerium (CeO₄) bonded to silicon oxide on the surface to be cleaned into water-soluble Ce³⁺, it is easily removed from the surface to be cleaned, thus improving the cleaning effect.

The reducing compound (B) may be selected as appropriate from those having a reducing function for the cerium compound-containing particles. Among them, the reducing compound (B) is preferably one or more types of compounds selected from the group consisting of gallic acid and its salt, gallic acid ester, ascorbic acid, uric acid, diphosphoric acid, and oxalic acid.

When the reducing compound (B) is used, the content of the reducing compound in the cleaning liquid is preferably 0.001 to 10 mass%, more preferably 0.005 to 8 mass%, and particularly preferably 0.01 to 5 mass% based on the total amount of the cleaning liquid.

### <Acidic Compound (C)>

The cleaning liquid disclosed herein may further comprise an acidic compound (C) other than the water-soluble polymer (A) and the reducing compound (B). The acidic compound (C) may be used, for example, for adjusting pH, and a compound having a function as a complexing agent may be used.

Either an organic acid or an inorganic acid can be suitably used as the acidic compound (C). In order to further improve the cleaning effect of the cleaning liquid, the cleaning liquid preferably comprises, as the acidic compound (C), an organic compound having one or more substituents selected from a carboxyl group, a phosphoryl group, a sulfonic acid group, and a hydroxyl group in the molecule and having a molecular weight of 1,000 g/mol or lower, and one or more types of acids selected from sulfuric acid, nitric acid, and phosphoric acid. Note that the hydroxyl group is preferably a phenolic hydroxyl group.

Further, examples of the acidic compound (C) having a function as a complexing agent include an organic compound having two or more substituents selected from a carboxyl group, a phosphoryl group, a sulfonic acid group, and a hydroxyl group in the molecule and having a molecular weight of 1,000 g/mol or lower. The complexing agent can be selected as appropriate from those which complexation-react with a metal component contained in the abrasive grains (cerium compound-containing particles) and a metal component contained in the residue derived from the substrate caused by the polishing, and used.

Specific examples of the aforementioned complexing agent include tetramethyl ethylenediamine (TMEDA), ethylenediaminetetraacetic acid (EDTA), N-hydroxyethyl ethylenediaminetriacetic acid (NHEDTA), nitrilotriacetic acid (NTA), diethylenetriamine pentaacetic acid (DPTA), ethanol diglycinate, citric acid, malic acid, gluconic acid, oxalic acid, phosphoric acid, tartaric acid, malonic acid, succinic acid, dimercaptosuccinic acid, glutaric acid, maleic acid, phthalic acid, fumaric acid, lactic acid, 2-hydroxyisobutyric acid, quinic acid, gluconic acid, lactobionic acid, phosphonoacetic acid, 3-phosphonopropionic acid, methyldiphosphonic acid, amino trismethylenephosphonic acid, ethylidene-diphosphonic acid, 1-hydroxyethane-1, 1-diphosphonic acid (HEDP), 1-hydroxypropylidene-1,1-diphosphonic acid, ethylamino bismethylenephosphonic acid, dodecylamino bismethylenephosphonic acid, nitrilotrismethylene phosphonic acid, ethylene diaminebismethylenephosphonic acid, ethylene diaminetetrakismethylenephosphonic acid, hexamethylenediamine tetrakismethylenephosphonic acid, diethylenetriamine pentamethylenephosphonic acid, and 1,2-propanediamine pentamethylenephosphonic acid, and ammonium salt.

When the acidic compound (C) is used, the content of the acidic compound (C) in the cleaning liquid is preferably 0.001 to 10 mass%, more preferably 0.005 to 8 mass%, and particularly preferably 0.01 to 5 mass% based on the total amount of the cleaning liquid.

In the cleaning liquid disclosed herein, regarding the water-soluble polymer (A), the reducing compound (B), and the acidic compound (C), the reducing compound (B) and the acidic compound (C) can be independently combined as long as the water-soluble polymer (A) is contained.

When there are metal wiring lines in the object to be cleaned, the cleaning liquid preferably comprises at least the water-soluble polymer (A) and the reducing compound (B). When it is necessary to lower pH while reducing the content of the water-soluble polymer (A), the cleaning liquid preferably comprises at least the water-soluble polymer (A) and the acidic compound (C).

### <Preservative>

The cleaning liquid disclosed herein may comprise a preservative. When the cleaning liquid comprises a preservative, the deterioration of its quality caused by microorganisms or the like is suppressed, so that a more excellent cleaning effect is obtained. The preservative can be selected as appropriate from known ones and used. However, among them, a heterocyclic aromatic compound is preferred in order to further improve the cleaning ability. Examples of heterocyclic compounds include an imidazole-based compound, a pyrazole-based compound, a thiazole-based compound, and a triazole-based compound.

Examples of imidazole-based compounds include imidazole, 2-ethyl-4-methylimidazole, 1,2-dimethylimidazole, 1-benzyl-2-methylimidazole, and 1-benzyl-2-phenylimidazole. Examples of pyrazole-based compounds include pyrazole, 3-methylpyrazole, and 3,5-dimethylpyrazole. Examples of thiazole-based compounds include benzisothiazoline, isothiazoline, 1,2-benzisothiazoline-3-one, 5-chloro-2-methyl-4-isothiazoline-3-one, 2-(thiocyanomethylthio) benzthiazole, 2-mercaptobenzthiazole, and 3-allyloxy-1,2-benzisothiazole-1,1-dioxide. Further, examples of triazole-based compounds include 1H-benzotriazole, 4-methyl-1H-benzotriazole, and 5-methyl-1H-benzotriazole.

When a preservative is used, the content of the preservative in the cleaning liquid is preferably 0.00001 to 0.1 mass%, more preferably 0.00005 to 0.05 mass%, and particularly preferably 0.0001 to 0.01 mass% based on the total amount of the cleaning liquid.

### <Basic Compound>

The cleaning liquid disclosed herein may comprise a basic compound. The basic compound is used for a pH adjustment or the like. Examples of basic compounds include monoethanolamine (MEA), diethanolamine, triethanolamine (TEA), morpholine, isopropylamine, hydroxyamine, diisopropanolamine, diglycolamine, triethylamine, N-methylmorpholine, methylethanolamine, N-aminopropylmorpholine, 3-amino-propanol, tetramethylammonium hydroxide (TMAH), ammonium hydroxide, tetraethylammonium hydroxide (TEAH), tetrapropylammonium hydroxide (TPAH), tetrabutylammonium hydroxide (TBAH), tributylmethylammonium hydroxide (TBMAH), benzyltrimethylammonium hydroxide (BTMAH), choline, choline hydroxide, ethyltrimethylammonium hydroxide, tris(2-hydroxyethyl) methylammonium hydroxide, diethyldimethylammonium hydroxide, and combinations thereof. Among them, the basic compound is preferably ammonium hydroxide, choline, monoethanolamine, hydroxyamine, or triethanolamine.

### <Water-Soluble Organic Solvent>

The cleaning liquid disclosed herein may comprise a water-soluble organic solvent. Examples of water-soluble organic solvents include, but are not limited to, propylene glycol (PG), glycol ether, aprotic solvents such as N-methylpyrrolidone (NMP), dimethyl sulfoxide (DMSO), dimethylacetamide (DMAC), sulfolane, and dimethylformamide (DMF), and combinations thereof.

### <Surfactant>

The cleaning liquid disclosed herein may comprise a surfactant. However, in order to adjust the surface tension of the cleaning liquid to 68 mN/m or higher, the surfactant is, if contained, preferably contained in a very small amount. Specifically, the content of the surfactant is preferably 0.01 mass% or less, and more preferably 0.001 mass% or less based on the total amount of the cleaning liquid. Further, particularly preferably, the surfactant is not substantially contained.

Note that "not substantially contained" means that the content is 0.0001 mass% or less based on the total amount of the cleaning liquid. Note that examples of surfactants include salts comprising suitable hydrophobicity such as alkyl carboxylate, alkyl polyacrylate, alkyl sulfate, alkyl phosphate, alkyl bicarboxylate, alkyl bisulfate, alkyl biphosphate, substituted aryl carboxylate, substituted aryl sulfate, substituted aryl phosphate, substituted aryl bicarboxylate, substituted aryl bisulfate, and substituted aryl biphosphate, long-chain alcohol, ethoxylated alcohol, an ethoxylated acetylene diol surfactant, polyethylene glycol alkyl ether, propylene glycol alkyl ether, glucoside alkyl ether, polyethylene glycol octylphenyl ether, polyethylene glycol alkyl phenyl ether, glycerol alkyl ester, polyoxyethylene glycol sorbitan alkyl ester, sorbitan alkyl ester, cocamide diethanolamine, dodecyldimethylamine oxide, a block copolymer of polyethylene glycol and polypropylene glycol, and polyethoxylated tallow amine.

### <Fluorine Atom-containing Inorganic Acid>

The cleaning liquid disclosed herein may comprise a fluorine atom-containing inorganic acid. However, the fluorine atom-containing inorganic acid may etch the substrate or metal wiring lines or the like formed on the substrate. Therefore, in order to suppress the damage to the surface to be cleaned, the fluorine atom-containing inorganic acid is, if contained, preferably contained in a very small amount. Specifically, the content of the fluorine atom-containing inorganic acid in the cleaning liquid is preferably 5 mM or less, more preferably 1 mM or less, and still more preferably 0.1 mM or less. Further, particularly preferably, the fluorine atom-containing inorganic acid is not substantially contained. Note that examples of fluorine atom-containing inorganic acids include hydrofluoric acid, hexafluorosilicic acid, tetrafluoroboric acid, and salts thereof.

### <Use of Cleaning Liquid>

The cleaning liquid disclosed herein can be suitably used as a cleaning liquid for removing abrasive grains (cerium compound-containing particles) from the surface to be cleaned, and also suitably used to remove organic components such as polymers contained in the abrasive.

Examples of surfaces to be cleaned include an exposed surface (the surface) of a semiconductor substrate, and the exposed surface may include a silicon dioxide surface and/or a silicon nitride surface. The surface to be cleaned may be an exposed surface which has been surface-polished by using an abrasive comprising abrasive grains. Further, the cleaning liquid disclosed herein can also be suitably used for cleaning a semiconductor substrate having an exposed surface comprising metal wiring lines because it can suppress the oxidation of the metal. Further, the cleaning liquid disclosed herein can also be suitably used for fine cerium compound-containing particles, and has an excellent cleaning effect, for example, for particles having an average particle diameter of 300 nm or smaller.

An object to be cleaned on which the cleaning liquid disclosed herein exhibits a particularly excellent effect is a semiconductor substrate which has already been subjected to a CMP process using an abrasive comprising cerium compound-containing particles as abrasive grains, and is a semiconductor substrate having an exposed surface on which an oxide film, a nitride film, or the like is exposed, and comprising exposed metal wiring lines. Cerium particles adsorbed on or bonded to the oxide film or the like remain on the exposed surface, but the cleaning liquid disclosed herein can suitably remove these particles.

Further, since the foam breakage of the cleaning liquid disclosed herein is excellent, it is suitable for cleaning a brush for cleaning a semiconductor substrate used in a CMP process, and the brush can be cleaned in a short time.

### [Cleaning Method]

A cleaning method according to the present disclosure comprises cleaning a surface to be cleaned to which a cerium compound has adhered by using the above-described cleaning liquid. Specifically, examples of cleaning methods include scrub cleaning in which a cleaning member such as a pad or a brush is physically brought into contact with the surface to be cleaned such as a semiconductor substrate while supplying the cleaning liquid to the surface to be cleaned, and cerium compound-containing particles or the like are removed, immersion-type cleaning in which an object to be cleaned having a surface to be cleaned is submerged in the cleaning liquid, spin drop cleaning in which the cleaning liquid is dropped on the object to be cleaned while rotating it, and spray-type cleaning in which the cleaning liquid is sprayed. In the immersion-type cleaning, an ultrasonic process may be performed for the cleaning liquid. The above-described cleaning process may be performed only once, or may be performed twice or more.

The temperature of the cleaning liquid may be adjusted as appropriate in consideration of the heat resistance and the like of the object to be cleaned. The temperature of the cleaning liquid may be adjusted as appropriate in a range of, for example, 10 to 60°C, and preferably 15 to 50°C.

The cleaning time may be adjusted as appropriate in a range of 10 seconds to 5 minutes, and preferably 20 seconds to 3 minutes.

In the cleaning method disclosed herein, after cleaning the object to be cleaned or the like with the above-described cleaning liquid, the object to be cleaned or the like may be further cleaned with water or the like when required, and the object to be cleaned or the like may be dried when required.

Further, the present disclosure provides a semiconductor device obtained by the above-described cleaning method. The semiconductor device obtained by the above-described cleaning method has a clean surface on which the amounts of abrasive grains and polishing residues are small.

### Examples

The present invention will be described hereinafter in a more concrete manner with reference to examples and comparative examples, but the present invention is not limited to these examples. Unless otherwise specified, the normal temperature is 20 to 25°C Note that Examples 1 to 11, 14 to 35, and 38 are examples according to the present disclosure, and Examples 12, 13, 36, and 37 are comparative examples.

### [Method for Measuring pH and Surface Tension]

### (pH)

pH of a cleaning liquid was measured by using a commercially-available pH meter while stirring the cleaning liquid using a magnetic stirrer. A pH meter "F-2000PI-S" and a ToupH electrode "9615S-10D" manufactured by HORIBA Ltd. were used as the pH meter.

### (Surface Tension of Aqueous Solution of Water-Soluble Polymer (A))

The surface tension of an aqueous solution comprising a water-soluble polymer (A) shown below at a concentration of 0.1 mass% was measured by a pendant drop method under a condition of a droplet volume of 5 µL by using a contact angle meter "DMo-502" manufactured by Kyowa Interface Science Co., Ltd. Note that measured values were calculated by using a ds/de method. Table 1 shows surface tensions of aqueous solutions of various water-soluble polymers (A).

### [Material]

The materials used in the examples are as shown below.
<Water-Soluble Polymer (A)>
   A-1: Poly(4-styrenesulfonic acid). Mw is 75,000.
   A-2: Poly(4-styrenesulfonic acid) ammonium salt. Mw is 75,000.
   A-3: Naphthalenesulfonic acid formalin condensate. Mw is 25,000.
   A-4: Naphthalenesulfonic acid formalin condensate ethanolamine salt. Mw is 25,000.
   A-5: Poly(2-acrylamide-2-methyl-1-propanesulfonic acid). Mw is 2,000,000.
   A-6: Fluorinated sulfonic acid polymer (A binary water-soluble fluorine copolymer comprising a tetrafluoroethylene (-CF₂CF₂₋) structure and an SO₃H group-containing fluoro-alkylene (-CF₂CF(OCF₂CF(CF₃)OCF₂CF₂SO₃H)-) structure in a molar ratio of 73:27. The concentration of the acidic group per unit mass was 1.40 mmol/g).
<Other Water-soluble Polymer>
   X-1: Dodecylbenzenesulfonic acid
<Reducing Compound (B)>
   B-1: Gallic acid
   B-2: Pyrogallol
   B-3: Ascorbic acid
   B-4: Hydroquinone
<Acidic Compound (C)>
   C-1: Nitric acid (0.1M)
   C-2: 1-Hydroxyethylidene-1,1-diphosphonic acid
   C-3: Citric acid
   C-4: Tartaric acid
   C-5: Phosphonoacetic acid

**[Table 1]**

| | | Surface tension (mN/m) |
|---|---|---|
| Water-soluble polymer (A) | A-1 | 72.5 |
| | A-2 | 70.5 |
| | A-3 | 72.5 |
| | A-4 | 72.5 |
| | A-5 | 71.8 |
| | A-6 | 71.7 |
| Other water-soluble polymer | X-1 | 29.9 |

### [Examples 1 to 13: Evaluation of Cleaning Ability/Foaming Property]

The cleaning abilities of the cleaning liquids of Examples 1 to 13 described later were evaluated by a method described below.

### <Cleaning Ability: Removing Performance for Cerium Oxide and Organic Component>

### (Preparation of Polished Substrate)

A square quartz glass plate having each side of 5 cm and a thickness of 1 mm was prepared as a substrate to be polished.

A commercially-available abrasive slurry (polishing slurry) comprising cerium oxide particles having an average particle diameter of 300 nm or smaller, an organic component(s) such as a polymer(s), a surfactant, and water was prepared.

One of the surfaces of the quartz glass plate was polished for 30 seconds by using a commercially-available CMP apparatus and the above-described abrasive. A "FAM12B" manufactured by SpeedFam was used as the CMP apparatus. A hard urethane pad was used as the polishing pad. Regarding detailed conditions, dressing was performed for 5 minutes before the polishing; brushing was 5 minutes; the polishing pressure was 144 g/rpm; and the polishing was performed for 5 minutes while pouring 30 cc of a chemical solution per minute over the quartz glass plate. A ceria-contaminated substrate was obtained by performing the polishing under the above-described conditions, rinsing the substrate several times with pure water, and storing the substrate under water.

### (Post-cleaning of Polished Substrate)

The obtained ceria-contaminated substrate was subjected to uniaxial PVA sponge cleaning (i.e., for each substrate, a cleaning process using 5 mL of the cleaning liquid was performed twice under conditions of 300 revolutions per minute and a cleaning speed of 12.5 mm/sec). A cleaned substrate was obtained by rinsing the substrate several times with pure water and then drying the substrate. The polished substrate subjected to the above-described series of processes is referred to as a "polished and post-cleaned substrate".

### (Amount of Residual Cerium Oxide After Post-cleaning and Evaluation of Removing Performance for Cerium Oxide)

Ceria-contaminated particles remaining on the polished and post-cleaned substrate were counted by using a particle inspection apparatus (LODAS-CI8 manufactured by LAZIN). The removing performance for cerium oxide was evaluated based on the criteria shown below.
A (Excellent): The particle count number after the post-cleaning is 800 or less.
B (Acceptable): The particle count number after the post-cleaning is 1,200 or less.
C (Defective): The particle count number after the post-cleaning is greater than 1,200.

### <Foaming Property: Ross-Miles Foam Height>

50 mL of a cleaning liquid was put in the lower part of a glass tube having a diameter of 50 mm in advance; a certain amount (200 mL) of the cleaning liquid was dropped from the upper part of the glass tube over 30 seconds; and a foaming ability was measured by reading (i.e., measuring) the height (mm) of the formed foam 30 seconds after the dropping.

### (Example 1)

A cleaning liquid of Example 1 was prepared by adding 0.01g of A-1 to 100g of ultrapure water, and stirring and mixing them at a room temperature (25°C). Table 2 shows formulations and evaluation results.

### (Examples 2 to 13)

The cleaning liquids for these examples were prepared in a manner similar to Example 1, except that the formulations were changed to those shown in Table 2. Table 2 shows formulations and evaluation results.

**[Table 2]**

| | | Example 1 | Example 2 | Example 3 | Example 4 | Example 5 | Example 6 | Example 7 | Example 8 | Example 9 | Example 10 | Example 11 | Example 12 | Example 13 |
|---|---|---|---|---|---|---|---|---|---|---|---|---|---|---|
| Ultrapure water [g] | | 100 | 100 | 100 | 100 | 100 | 90 | 99 | 100 | 100 | 100 | 99 | 100 | 100 |
| Water-soluble polymer (A) | A-1 [g] | 0.01 | 0.01 | 0.01 | | | | | | | | | | |
| | A-2 [g] | | | | 0.01 | | | | | | | | | |
| | A-3 [g] | | | | | 0.01 | 0.01 | 0.01 | | | | | | |
| | A-4 [g] | | | | | | | | 0.01 | | | | | |
| | A-5 [g] | | | | | | | | | 0.01 | | | | |
| | A-6 [g] | | | | | | | | | | 0.01 | 0.01 | | |
| Other water-soluble polymer | X-2 [g] | | | | | | | | | | | | 0.01 | |
| Acidic compound (C) (C) | C-1 [g] | | 10 | 1 | | | 10 | 1 | | | | 1 | | 1 |
| | C-2 [g] | | | | 0.1 | | | | 0.1 | | | | | |
| Active component concentration (%) | | 0.010% | 0.010% | 0.010% | 0.010% | 0.010% | 0.010% | 0.010% | 0.010% | 0.010% | 0.010% | 0.010% | 0.010% | 0.000% |
| pH | | 4.10 | 1.98 | 3.02 | 2.84 | 3.67 | 1.98 | 2.90 | 2.97 | 3.81 | 4.32 | 2.97 | 3.48 | 3.19 |
| Number of defects | | A | A | A | A | A | A | A | A | A | A | A | C | C |
| Ross-Miles foam height (mm) | | < 5 | <5 | <5 | <5 | < 5 | < 5 | < 5 | < 5 | <5 | <5 | <5 | 50 | <5 |

### [Examples 14 to 38: Evaluation of Cleaning Ability and Anticorrosion Property]

For the cleaning liquids of Example 14 to 38 described later, their anticorrosion properties were also evaluated in addition to the cleaning abilities. Note that the method for evaluating the cleaning ability was similar to that in the above-described Examples 1 to 13.

### <Anticorrosion Property: Anticorrosion Property for Copper>

A silicon wafer piece on which a Cu film was formed was impregnated with the cleaning liquid and heated. Then, changes in the Cu film thickness and the surface shape were observed.

### (Preparation of Test Substrate Piece)

A rectangular Cu film wafer piece having a length of 2 cm and a width of 4 cm was prepared, and the thickness of the Cu film was measured in advance by using a resistance measuring instrument (VR300DEC manufactured by Kokusai Electric Semiconductor Service Corporation).

### (Test Method)

10 mL of the cleaning liquid was put into a vinyl pack; the above-described Cu film wafer piece was impregnated therewith; and the Cu film wafer piece was heated in a constant temperature bath at 60°C for 60 minutes. After the test, the substrate was rinsed with ultrapure water, rinsed with isopropanol, and dried. The resultant substrate was used as the test substrate.

### (Amount of Residual Cerium Oxide After Post-cleaning and Evaluation of Removing Performance for Cerium Oxide)

The corrosivity of the copper film by the cleaning liquid was evaluated from the difference of the thickness of the copper film of the substrate that was measured after the test in a similar manner. Further, the shape of the surface of the copper film was observed through an observation using an optical microscope, and evaluated based on the criteria shown below.
A (Excellent): There were almost no changes in the shape of the copper film.
B (Acceptable): Slight discoloration or irregularities were confirmed on the surface of the copper film.
C (Defective): Significant discoloration and changes in the shape were observed.

### <Elusion Property: Elusion Property of Copper for Cleaning Liquid>

### (Preparation of Test Substrate Piece)

A wafer on which a Cu film was formed was cut into a rectangular wafer piece having a length of 2 cm and a width of 4 cm.

### (Test method)

12 mL of a cleaning liquid was put into a vinyl pack; the above-described Cu film wafer piece was impregnated therewith; and the Cu film waver piece was heated in a constant temperature bath at 25°C for 10 minutes. The concentration of Cu contained in the cleaning liquid after the test was quantified (ppm) by ICP optical emission spectrometry (ICPE-9800 manufactured by Shimadzu Corporation).

### (Examples 14 to 38)

The cleaning liquids for these examples were prepared in a manner similar to Example 1, except that the formulations were changed to those shown in Tables 3 and 4. Tables 3 and 4 show formulations and evaluation results.

**[Table 3]**

| | | Example 14 | Example 15 | Example 16 | Example 17 | Example 18 | Example 19 | Example 20 | Example 21 | Example 22 | Example 23 | Example 24 | Example 25 | Example 26 |
|---|---|---|---|---|---|---|---|---|---|---|---|---|---|---|
| Ultrapure water [g] | | 100 | 100 | 100 | 100 | 100 | 100 | 100 | 100 | 100 | 100 | 100 | 100 | 100 |
| Water-soluble polymer (A) | A-1 [g] | 003 | 0.01 | 0.01 | 0.01 | 0.01 | | | | | | | | |
| | A-2 [g] | | | | | | 0.01 | 0.01 | 0.01 | 0.01 | | | | |
| | A-3 [g] | | | | | | | | | | 0.01 | 0.01 | 0.01 | 0.01 |
| | A-4 [g] | | | | | | | | | | | | | |
| | A-5 [g] | | | | | | | | | | | | | |
| | A-6 [g] | | | | | | | | | | | | | |
| Other water-soluble polymers | X-2 [g] | | | | | | | | | | | | | |
| Reducing compound (B) | B-1 [g] | | 0.013 | | | | 0.063 | 0.063 | 0.063 | 0.063 | 0.063 | | | |
| | B-2 [g] | | | 0.093 | | | | | | | | 0.093 | 0.093 | |
| | B-3 [g] | 0.018 | | | 0.018 | 0.088 | | | | | | | | 0.088 |
| | B-4 [g] | | | | | | | | | | | | | |
| Acidic compound (C) | C-1 [g] | | | | | | | | | | | | 1 | |
| | C-2 [g] | | | | | | | | | 0.044 | | | | |
| | C-3 [g] | | | | | | 0.096 | | | | | | | |
| | C-4 [g] | | | | | | | 0.075 | | | | | | |
| | C-5 [g] | | | | | | | | 0.070 | | | | | |
| Active component concentration (%) | | 0.048% | 0.023% | 0.103% | 0.028% | 0.098% | 0.073% | 0.073% | 0.073% | 0.073% | 0.068% | 0.098% | 0.098% | 0.093% |
| pH | | 3.19 | 4.00 | 3.34 | 3.56 | 3.20 | 2.81 | 2.76 | 2.24 | 3.43 | 3.93 | 3.25 | 3.02 | 3.17 |
| Number of defects | | A | A | A | A | A | B | B | B | A | A | B | A | A |
| Anticorrosion property | Change in film thickness [nm] | -30 | 6 | -42 | -18 | -2 | -59 | -56 | -77 | -25 | -26 | -23 | -29 | -6 |
| | Change in appearance | B | A | B | B | A | B | B | B | A | A | A | A | A |
| Elusion property | Cu concentration [ppm] | 1.4 | 1.2 | 1.5 | 1.4 | 1.3 | 1.9 | 1.8 | 2.1 | 1.6 | 1.8 | 1.8 | 1.9 | 1.6 |

**[Table 4]**

| | | Example 27 | Example 28 | Example 29 | Example 30 | Example 31 | Example 32 | Example 33 | Example 34 | Example 35 | Example 36 | Example 37 | Example 38 |
|---|---|---|---|---|---|---|---|---|---|---|---|---|---|
| Ultrapure water [g] | | 100 | 100 | 100 | 100 | 99 | 100 | 100 | 100 | 100 | 99 | 100 | 100 |
| Water-soluble polymer (A) | A-1 [g] | | | | | | | | | | | | 0.01 |
| | A-2 [g] | | | | | | | | | | | | |
| | A-3 [g] | 0.01 | | | | | | | | 0.01 | | | |
| | A-4 [g] | | 0.01 | 0.01 | 0.01 | 0.01 | 0.01 | | | | | | |
| | A-5 [g] | | | | | | | 0.01 | | | | | |
| | A-6 [g] | | | | | | | | 0.01 | | | | |
| Other water-soluble polymers | X-2 [g] | | | | | | | | | | | | |
| Reducing compound (B) | B-1 [g] | | 0.063 | | | 0.063 | 0.063 | 0.063 | | | 0.063 | 0.063 | |
| | B-2 [g] | | | 0.093 | | | | | | | | | |
| | B-3 [g] | 0.088 | | | 0.088 | | | | 0.088 | | | | |
| | B-4 [g] | | | | | | | | | 0.062 | | | |
| Acidic compound (C) | C-1 [g] | | | | | 1 | | | | | 1 | | |
| | C-2 [g] | | 0.044 | 0.044 | | | | | | | | | |
| | C-3 [g] | | | | | | | | | | | 0.01 | |
| | C-4 [g] | | | | | | | | | | | | |
| | C-5 [g] | | | | | | 0.014 | | | | | | |
| Active component concentration (%) | | 0.093% | 0.068% | 0.098% | 0.093% | 0.068% | 0.068% | 0.068% | 0.093% | 0.067% | 0.063% | 0.063% | 0.010% |
| pH | | 3.17 | 3.38 | 3.38 | 3.37 | 3.19 | 3.16 | 4.05 | 3.30 | 3.66 | 3.11 | 2.83 | 4.10 |
| Number of defects | | A | A | A | B | A | A | A | A | B | C | C | A |
| Anticorrosion property | Change in film thickness [nm] | -6 | -33 | -30 | -5 | -34 | -46 | -21 | -3 | -49 | -29 | -33 | -80 |
| | Change in appearance | A | A | B | A | B | B | B | A | C | A | B | C |
| Elusion property | Cu concentration [ppm] | 1.5 | 1.7 | 1.8 | 1.4 | 1.7 | 1.9 | 1.6 | 1.6 | 3.9 | 1.8 | 1.9 | 3.1 |

### [Summary of Results]

As shown in Tables 2 to 4, it was shown that each of the cleaning liquids of Examples 1 to 11, 14 to 35, and 38, each of which comprised a water-soluble polymer (A) comprising a sulfonic acid group-containing water-soluble polymer (a1) and comprising a sulfonic acid, which has a surface tension of 68 mN/m or higher at a concentration of 0.1 mass%, exhibited excellent removing performance for cerium compound-containing particles while suppressing foaming.

Further, as shown in Tables 3 and 4, it was shown that each of the cleaning liquid of Examples 14 to 34, each of which comprised one of B-1 to B-3 as a reducing compound and comprising the above-described water-soluble polymer (A), exhibited excellent removing performance for cerium compound-containing particles while suppressing the corrosion of metal wiring lines.

### Industrial Applicability

The cleaning liquid according to the present disclosure is useful as a cleaning liquid used in a manufacturing process of a substrate for a semiconductor device, and can shorten the cleaning process for the substrate to which cerium compound-containing particles have adhered, improve the reliability of the obtained semiconductor device, and thereby improve the productivity of semiconductor devices.

This application is based upon and claims the benefit of priority from Japanese Patent Application 2023-199775 filed on November 27, 2023, the disclosure of which is incorporated herein in its entirety by reference.

## Claims

1. A cleaning liquid for removing a cerium compound, comprising a water-soluble polymer (A) comprising a sulfonic acid group-containing water-soluble polymer (a1), and water wherein
pH is 7 or lower, and
a surface tension of an aqueous solution comprising the water-soluble polymer (A) at a concentration of 0.1 mass%, measured by a pendant drop method at 22°C is 68 mN/m or higher.

2. The cleaning liquid according to claim 1, wherein the sulfonic acid group-containing water-soluble polymer (a1) has one or more types of repeating units selected from an aromatic sulfonic acid, a perfluoroalkyl sulfonic acid, and salts thereof.

3. The cleaning liquid according to claim 1, wherein a ratio (Nc/Ns) of the number of carbons (Nc) excluding counter-cations of a sulfonic acid contained in the repeating unit having at least one sulfonic acid group, contained in the sulfonic acid group-containing water-soluble polymer (a1) to a total number (Ns) of sulfonic acids and salts thereof is 7 to 15.

4. The cleaning liquid according to claim 1, further comprising a reducing compound (B).

5. The cleaning liquid according to claim 4, wherein the reducing compound (B) comprises one or more types of compounds selected from the group consisting of gallic acid, gallic acid esters, pyrogallol, ascorbic acid, uric acid, pyrophosphoric acid, and oxalic acid.

6. The cleaning liquid according to claim 1, further comprising an acidic compound (C) other than the water-soluble polymer (A) and the reducing compound (B).

7. The cleaning liquid according to claim 6, wherein the acidic compound (C) comprises an organic compound having at least one substituent selected from a carboxyl group, a phosphoryl group, a sulfonic acid group, and a hydroxyl group in a molecule and having a molecular weight of 1,000 g/mol or lower, and one or more types of acids selected from sulfuric acid, nitric acid, and phosphoric acid.

8. The cleaning liquid according to claim 6, wherein the acidic compound (C) comprises an organic compound having at least two substituents selected from a carboxyl group, a phosphoryl group, a sulfonic acid group, and a hydroxyl group in a molecule and having a molecular weight of 1,000 g/mol or lower.

9. The cleaning liquid according to claim 1, wherein pH is 1 to 5.

10. The cleaning liquid according to claim 1, further comprising a preservative.

11. The cleaning liquid according to claim 1, wherein the water-soluble polymer (A) is contained in 0.001 to 10 mass%.

12. The cleaning liquid according to claim 4, wherein the reducing compound (B) is contained in 0.001 to 10 mass%.

13. The cleaning liquid according to claim 6, wherein the acidic compound (C) is contained in 0.001 to 10 mass%.

14. The cleaning liquid according to claim 1, wherein a Ross-Miles foam height at 25°C is 30 mm or lower.

15. The cleaning liquid according to claim 1, wherein an amount of elution of Cu when a silicon substrate on which a Cu film is formed is submerged in 12 mL of an aqueous solution comprising the water-soluble polymer (A) at 25°C for 10 minutes is 3.0 ppm or less.

16. The cleaning liquid according to any one of claims 1 to 15, wherein the cleaning liquid is for cleaning a semiconductor substrate to which a cerium compound has adhered.

17. The cleaning liquid according to claim 16, wherein the semiconductor substrate has an exposed surface comprising a metal wiring line on at least a part thereof.

18. The cleaning liquid according to any one of claims 1 to 15, wherein the cleaning liquid is for cleaning a brush to which a cerium compound has adhered, used for cleaning a semiconductor substrate.

19. The cleaning liquid according to any one of claims 1 to 15, wherein the cleaning liquid is for cleaning an object to be cleaned of which a surface has been polished by using an abrasive comprising cerium compound-containing particles.

20. The cleaning liquid according to claim 19, wherein an average particle diameter of the cerium compound-containing particles is 300 nm or smaller.

21. A cleaning method comprising cleaning a surface to be cleaned to which a cerium compound has adhered by using a cleaning liquid according to any one of claims 1 to 15.

22. A method for manufacturing a semiconductor device comprising preparing a semiconductor substrate polished with an abrasive comprising cerium compound-containing particles, and cleaning a polished surface of the semiconductor substrate by using a cleaning liquid according to any one of claims 1 to 15.
